**Europäisches Patentamt**

**European Patent Office**

**Office européen des brevets**

(19)

(11) Publication number : **0 507 539 A2**

## (12) EUROPEAN PATENT APPLICATION

(21) Application number : **92302811.2**

(22) Date of filing : **31.03.92**

(51) Int. Cl.⁵ : **H01L 39/24**

(30) Priority : **01.04.91 US 678407**

(43) Date of publication of application :
**07.10.92 Bulletin 92/41**

(84) Designated Contracting States :
**DE GB NL**

(71) Applicant : **GENERAL ELECTRIC COMPANY
1 River Road
Schenectady, NY 12345 (US)**

(72) Inventor : **Savkar, Sudhir Dattatraya
2344 Jade Lane
Schenectady, New York 12309 (US)**
Inventor : **Borst, Keith Milton
191 West Glenville Road
Scotia, New York 12302 (US)**

(74) Representative : **Pratt, Richard Wilson et al
London Patent Operation G.E. Technical
Services Co. Inc. Essex House 12/13 Essex
Street
London WC2R 3AA (GB)**

(54) **Method of making oriented dielectric films on metal substrates and articles formed thereby.**

(57)   Strontium titanate (SrTiO₃) is deposited on a metallic substrate by RF sputtering to create a deposit layer. The deposit layer can be utilized as a high capacity capacitor by itself or the deposit layer can be laser treated and later a layer of superconductor is deposited on top to create a highly conductive superconductor.

FIG. 2

EP 0 507 539 A2

## Background of the Invention

### Field of the Invention

This invention relates to strontium titanate, hereinafter referred to as $SrTiO_3$, films of the type that are oriented so that the film's (100) face is parallel to the surface plane of the substrate. Such structures of this type, as discussed more completely in the following description of the invention, generally allow the $SrTiO_3$ film to be deposited such that a high density capacitor or a buffer layer for a superconductor can be created. In particular, $SrTiO_3$ is deposited on a metal substrate by an RF sputtering process. In one embodiment, the deposition of the $SrTiO_3$ on the substrate can create a high density capacitor. In a second embodiment, a buffer layer for a superconductor may also be formed if the initially deposited film is then subjected to a $CO_2$ laser beam which recrystallizes the buffer layer to create precisely aligned molecular structures that can assist in properly orienting the later deposited superconductor layer. This invention relates to certain unique capacitors and buffer layers and the production means in association therewith.

There is a practical application of high transition temperature superconducting materials, hereinafter referred to as Hi-Tc materials, or the temperature at which the superconductor becomes superconductive especially in the use of ceramics in the superconductor. Modified perovskites exhibit excellent superconductive properties but are brittle and cannot sustain any tensile strains. Such tensile strains develop, for example, when the superconductor is wrapped around a bobbin to form a superconductive winding. It would then be desirable to mount the Hi-Tc material on a metal backing which could withstand the tensile strains, then in applications such as superconductive windings, the conductor could be wound while keeping the Hi-Tc ceramic material on the neutral axis which should be practically strain free.

### Description of Related Art

Prior to the present invention, as set forth in general terms above and more specifically below, it was known in the production of substrates for superconductors to employ the use of a single crystal of a perovskite material such as $SrTiO_3$. Such single crystals may even attain the size of up to 4" in diameter. However, such single crystal substrates are impractical when being applied to superconductive windings because the single crystal can neither be grown long enough nor continuously wound on bobbins to fabricate magnets. Also, single crystals cannot be strung together conveniently to form a electrically continuous winding.

In another area concerning the production of buffer layers on a superconductive winding, a thin film of barium fluoride ($BaF_2$) was used as a buffer layer between the metal substrate and the superconducting film. While the $BaF_2$ buffer improved the superconducting properties of a $YBa_2Cu_3O_{7-x}$ superconductor, hereinafter referred to as YBCO, the superconducting properties of the YBCO could be improved if the buffer layer was constructed of a material, preferably, a perovskite, which is more compatible with the YBCO, which can be classified as a modified perovskite.

Finally, no attempts have been made to employ a RF sputtering process in which the material being deposited as the substrate can act as both a buffer layer for a superconductor and a high density capacitor. Therefore, the use of a material in an RF sputtering process that is more compatible with the superconductor and can be deposited to form buffer layers for the superconductor and high density capacitors would be still more advantageous.

It is apparent from above that there exists a need in the art for an RF sputterable material which increases the superconductivity of the superconductive winding, and which can at least be deposited at the same deposition rates as known RF sputterable materials, but which at the same time can create either a buffer layer for the superconductor or a high density capacitor. It is a purpose of this invention to fulfill this and other needs in the art in a manner more apparent to the skilled artisan once given the following disclosure.

## Summary of the Invention

Generally speaking, this invention fulfills these needs by providing a method for creating a thin film or a buffer layer on a tape substrate comprising the steps of cleaning said substrate, polishing said substrate, etching said substrate, depositing a portion of a target of strontium titanate by on said substrate RF sputtering to form a deposit layer on said substrate, cooling said deposit layer and said substrate and impinging a laser beam on said layer to form a buffer layer. Further, a superconductor is formed by depositing a superconductor material on said buffer layer.

In certain preferred embodiments the substrate is a metal such as molybdenum and the target material is made of $SrTiO_3$. Those practiced in the art will recognize that the principles can be used with other target materials such as potassium tantalate ($KTaO_3$) although the individual steps may be modified. The laser beam, which is employed is created by a $CO_2$ laser. If it is desired to produce a high density capacitor, the steps of impinging the laser beam on the buffer layer and depositing a superconductor material on said layer may be omitted.

In another further preferred embodiment, the $SrTiO_3$ is deposited on an substrate by the RF sputtering process such that the (100) face of the $SrTiO_3$ molecule is parallel to the surface plane of the substrate which assists in properly orienting the c-axis of the superconductor which is later deposited on top of the buffer layer and, additionally, properly aligns the deposited $SrTiO_3$ molecule to create a high density capacitor.

In particularly preferred embodiments, the superconductor buffer layer method of this invention consists essentially of a tape of metal substrate which is cleaned and etched, the substrate is coated by RF sputtering with a deposit of $SrTiO_3$ to create a buffer layer, the buffer layer is cooled, and the buffer layer is impinged with a laser method of a $CO_2$ laser to more accurately align the (100) face of the buffer layer with respect to the surface plane of the substrate which then should properly align the c-axis of the superconductor. If a high density capacitor is desired, the step of impinging the buffer layer with the laser may be omitted.

The preferred RF sputtering deposition method according to this invention, offers the following advantages: improved hospitality to superconducting perovskite on the buffer layer, good capacitance characteristics of the capacitor, excellent economy; good safety characteristics; and ease of operation. In fact, in many of the preferred embodiments, these factors of improved hospitality to superconducting properties and economy are optimized to an extent considerably higher than heretofore achieved in prior, known deposition methods.

## Brief Description of the Drawings

The above and other features of the present invention which will become more apparent as the description proceeds are best understood by considering the following detailed description in conjunction with the accompanying drawings wherein like numbers represent like parts through several views and in which:

Figure 1 is a schematic drawing of the deposited layer with the (100) face parallel to the surface plane of the substrate and the YBCO with its c-axis normal to the surface of the substrate deposited on top;

Figure 2 is a schematic drawing of an RF sputtering process, according to the present invention;

Figure 3 is a schematic drawing of the laser treatment of the buffer layer, according to the present invention;

Figures 4a and 4b are graphical representations of the (100) orientation of the of the $SrTiO_3$ deposited layer prior to and after laser treatment, respectively;

Figure 5 is a photographic presentation of the $SrTiO_3$ layer after being deposited on the substrate.

## Detailed Description of the Invention

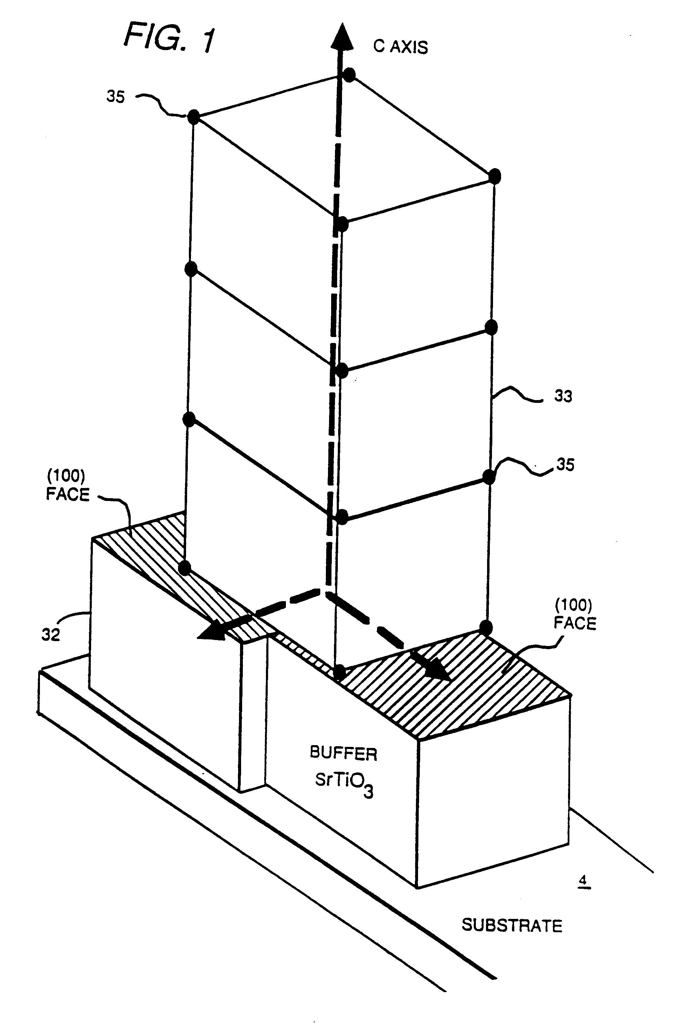

With reference first to Figure 1, there is illustrated a schematic drawing of a buffer layer of $SrTiO_3$ 32 after being deposited upon a substrate 4 with a layer 33 of YBCO deposited on top of the buffer layer 32. With respect to the buffer layer, the term (100) face is evident from the illustration. Also, the orientation of the (100) face with respect to the substrate surface can be discerned, in that, the (100) face of the buffer is parallel to the plane of the substrate surface upon which the buffer layer is located. The (100) face becomes oriented in this manner due to the inherent nature of the molecular structure of the $SrTiO_3$ as it is deposited on the surface of substrate during the RF sputtering process.

With respect to the YBCO superconductor, the c-axis of the superconductor is oriented upwardly from the substrate surface. The c-axis is positioned upwardly due to the inherent nature of the YBCO superconductor as it is deposited on the hospitable buffer layer. It is important to recognize that in order for the YBCO superconductor to properly conduct electricity, the planes 35 of copper (Cu) atoms contained within the adjacent YBCO crystal lattice structures must line up along the length of the YBCO layer. The proper alignment of the (100) face of the $SrTiO_3$ provides a buffer layer which should allow the YBCO superconductor to be deposited upon the buffer layer such that the planes 35 of Cu atoms should be aligned. In order to even further increase the precision of the alignment of the planes 35 of Cu atoms prior to deposition of the YBCO superconductor, the buffer layer is treated with a laser beam of a $CO_2$ laser which more precisely orients the (100) face of the buffer. However, if it is desired to only create a high capacitance capacitor, then the laser treatment and deposition of the YBCO superconductor can be omitted. A more specific discussion of the capacitor and laser treatment of the buffer layer are described below.

Finally, regarding the YBCO superconductor, the YBCO can be classified as a modified perovskite while $SrTiO_3$ is materially classified as a perovskite. Thus, when the YBCO is deposited upon the $SrTiO_3$, the interface between the two compounds remains relatively stable which keeps the planes of Cu atoms of the YBCO in proper alignment along the length of the superconductor.

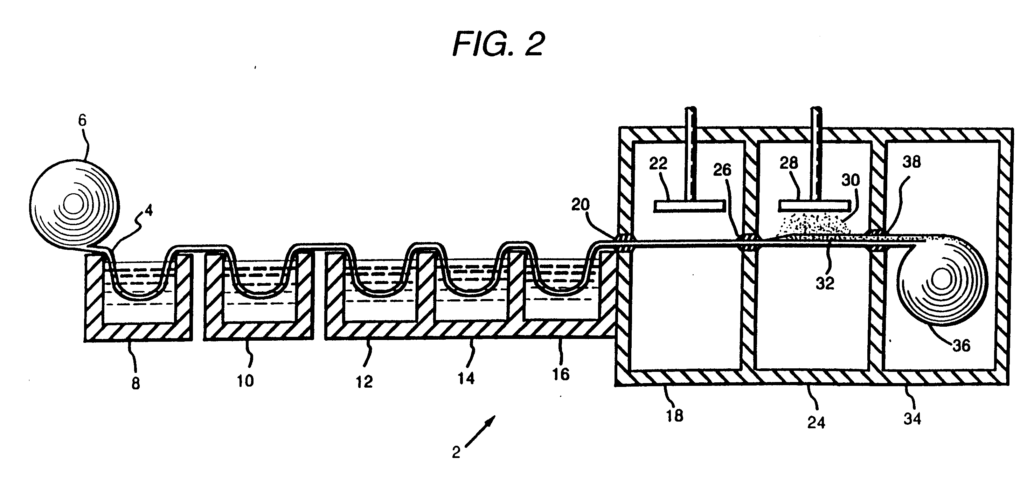

With respect to Figure 2, RF sputtering apparatus 2 for depositing $SrTiO_3$ on a substrate 4 is shown. Tape substrate 4 which is, preferably, any suitable metallic substrate, such as molybdenum is initially wound on coil 6. In order to clean substrate 4, coil 6 is unwound and substrate 4 is conventionally degreased by any suitable Freon® solvent in degreasing vat 8. Substrate 4 is then passed through an electropolishing station 10 where substrate 4 is electropolished by materials appropriate for the particular metal substrate such that, preferably, there are no scratches greater than 45Å in substrate 4. Next, substrate 4 is subjected to ultrasonic cleaning station 12 where substrate 4 is ultrasonically cleaned by, preferably, de-ionized water. The ultrasonic cleaning in station 12 is followed by another ultrasonic cleaning station 14 where substrate 4 is further ultrasonically cleaned by, preferably, acetone. The ultrasonic cleaning in station 14, preferably, is carried out for approximately 20 minutes. Finally, substrate 4 passes through another ultrasonic cleaning station 16, where substrate 4 is ultrasonically cleaned by, preferably, methanol, for approximately 10 minutes.

After substrate 4 has been cleaned, substrate 4 passes through a conventional vacuum seal 20 into a conventional sputter etching chamber 18. In chamber 18, the pressure is, preferably, drawn down from an ambient pressure to 2 x 10-6 Torr and held for 40 minutes to allow for substantially any residual outgassing from substrate 4. The outgassing is necessary because the substrate 4 usually contains tiny pores which can trap gas bubbles. If the gas bubbles are not removed, the gas bubbles may affect the interface between the substrate and the buffer layer or capacitor. After chamber 18 is evacuated, chamber 18 is then back filled by a conventional back fill apparatus (not shown) with, preferably, 10 microns of research grade argon (Ar). Once chamber 18 is back filled, the surface of substrate 4 is cleaned by sputter etching, preferably, for 20 minutes at 150 watts, while keeping the surface of substrate 4 approximately 1.75 inches from cathode 22.

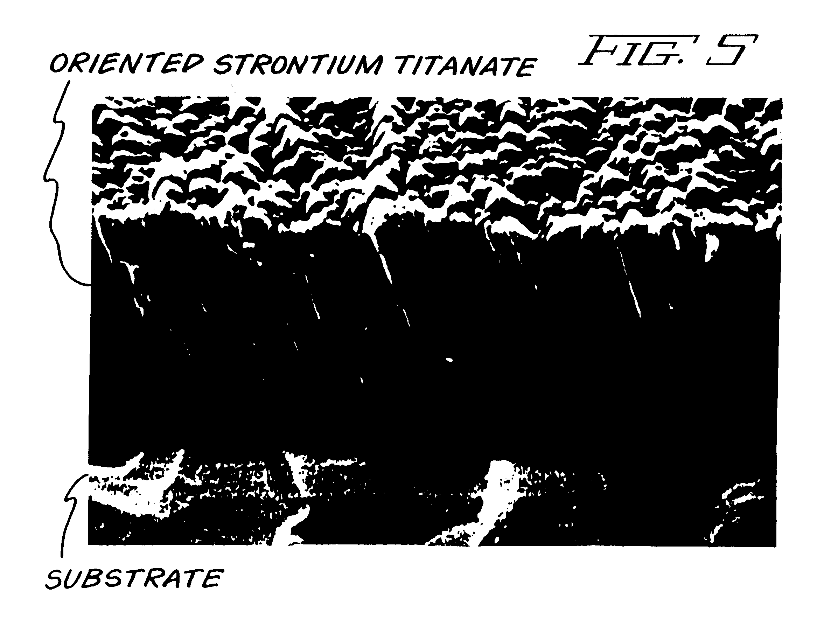

Once substrate 4 has been sputter etched in chamber 18, substrate 4 then moves past a conventional high vacuum seal 26 into a conventional depositing chamber 24. Sputtering is initiated such that excited Ar molecules strike target 28 to create a plume 30 of $SrTiO_3$ which is deposited on substrate 4 to create deposit layer 32. In particular, sputtering from target 28 is, preferably, carried out for approximately 5 hours which produces a deposit layer 32 having a thickness of approximately 2 microns. Finally, substrate 4 with deposit layer 32 moves past a conventional high vacuum seal 38 and into a conventional evacuated cooling chamber 34 where substrate 4 is cooled in chamber 34 for approximately 5 hours. After substrate 4 is cooled, it is rolled by conventional rolling techniques into roll 36. The resulting deposited 32 film is be polycrystalline. If the film 32 is thick enough, roughly more than one (1) micron thick, the morphology of the upper parts of film 32, regardless of the structure near substrate 4, is columner with the (100) face parallel to the plane of the substrate surface. In other words, $SrTiO_3$ films of sufficient thickness, on metallic substrates, have a strong preference to grow with the (100) face parallel to the plane of the substrate. This tendency, of columner grains of crystals stacked with the (100) faces oriented parallel to the fat face of the substrate, is preferred over any other orientation after deposition on the substrate surface. These results are illustrated in Figure 5 which shows a representative film of $SrTiO_3$ deposited on a molybdenum substrate.

It is to be understood that the process for creating deposit layer 32 on substrate 4 can be adapted for batch production with a few minor changes. In particular, substrate 4 would have to be cut into pieces of a suitable length and width. Also, the pieces would have to be placed step by step into each of the chambers 8, 10, 12, 14, 16, 18, 24 and 34. Also, after the pieces are sputter etched, target 28 should be conventionally "cleaned" by establishing a RF plasma near its surfaces. This is done to bring target 28 to steady state, a condition which can be verified by conventionally monitoring the vacuum and sputtering power until they are stabilized. Finally, vacuum seals 38 and 26 may not be necessary because there is no need to insure the vacuum and integrity of chamber 24.

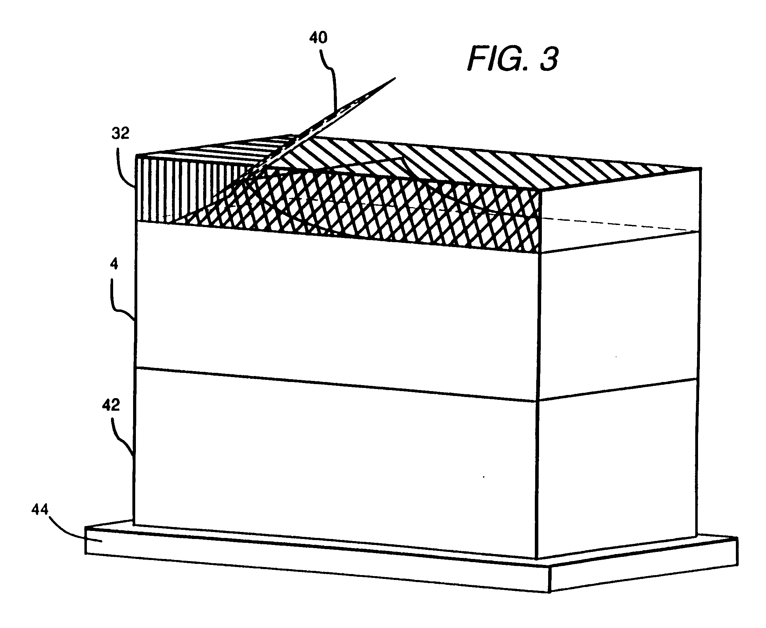

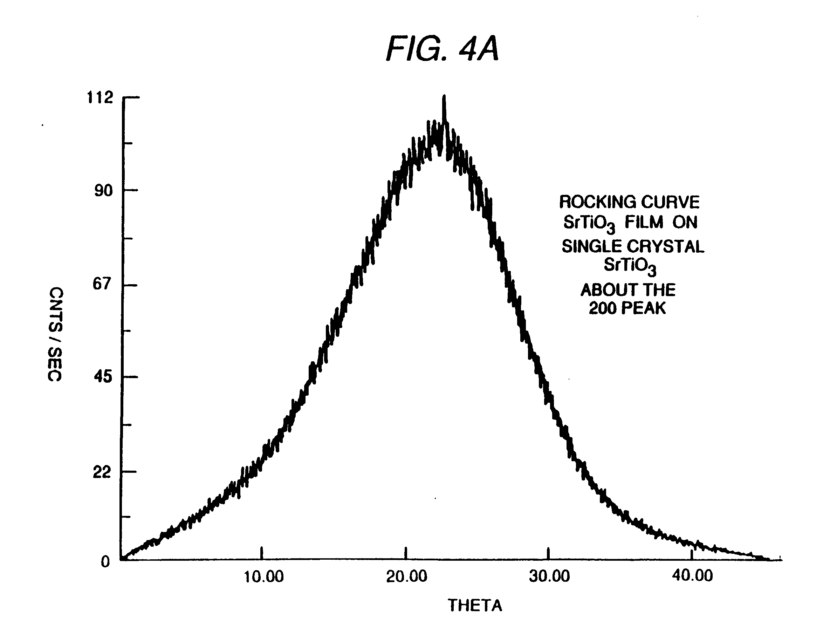

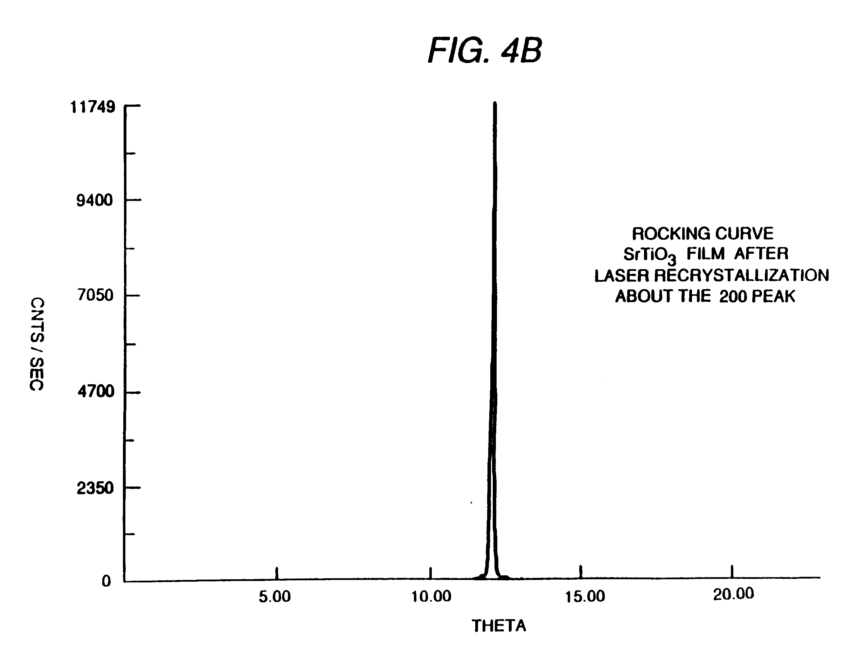

With respect to Figure 3, if it is desired to create a buffer layer from deposited layer 32, deposited layer 32 must be impinged by, preferably, a laser beam 40 from a conventional 1000W $CO_2$ laser (not shown). In particular, substrate 4 with deposited layer 32 is mounted on a conventional heater block 42 which, in turn, is mounted on a conventional X-Y traverse 44. Laser beam 40 is then impinged upon layer 32 at a wavelength, preferably, of 10μm so that the (100) faces of all of the $SiTiO_3$ molecules in the layer 32 are more precisely oriented with respect to substrate 4 such that the (100) faces are fairly precisely parallel to the plane of the surface of substrate 4 upon which layer 32 is deposited. This laser treatment further increase the precision of the orientation of the (100) faces of layer 32 is depicted in Figures 4a and 4b.

Figure 4a shows a standard rocking curve for a $SrTiO_3$ film about the (200) peak. The rocking curve was measured around the strong peak of (200). However, the (100) behavior is essentially the same. As can be seen, prior to laser treatment, a majority of the $SrTiO_3$ deposit has a lattice structure whose angular orientation (theta) with respect to the substrate surface is distributed with a peak around 22°. Consequently, when the YBCO is deposited on layer 32, the randomness of the orientation of the (100) faces of the $SiTiO_3$ layer may create a lack of alignment of the c-axis in the YBCO layer which can, ultimately, affect the superconductive properties of the YBCO layer.

Once layer 32 is laser recrystallized though, the lack of uniformity of the orientation of the (100) faces virtually disappears as shown in Figure 4b. It so happened that the measurement after recrystallization was carried around the (100) peak, but the behavior of the (200) peak is the same. In particular, Figure 4b shows that after laser treatment, the rocking curve about the (100) peak of almost all of the $SiTiO_3$ film is concentrated around 12° with a very narrow spread therefrom. Consequently, this improvement in orientation allows the YBCO molecules in superconductor layers to fairly accurately align along the length of the YBCO layer and increase the superconductive properties of the YBCO layer.

On the other hand, in order to produce a high density capacitor, layer 32 need not be laser treated. The capacitance properties of layer 32 as originally manufactured prior to laser treatment are sufficient to create a high density capacitor. In fact, the dielectric constant parallel to the axis normal to the (100) face (for simplicity we refer to this as the c-axis) of a $SiTiO_3$ molecule (190 at 26 degrees K and 100 KHz) is approximately twice the value along either of the other axes (85 for the same conditions imposed on the c-axis.)

Once given the above disclosure, many other features, modifications and improvements will become apparent to the skilled artisan including the use alternative perovskites such as $KTaO_3$. Such features, modifications and improvements are, therefore, considered to be a part of this invention, the scope of which is to be determined by the following claims.

## Claims

1. A method for creating a buffer layer on a superconductor having a substrate which is comprised of the steps of:

    cleaning said substrate;

    polishing said substrate;

    etching said substrate;

    depositing a portion of a target of strontium titanate on said substrate by RF sputtering to form a deposit layer on said substrate;

    cooling said deposit layer and substrate; and

    impinging a laser beam on said deposit layer.

2. The method for creating a buffer layer on a superconductor, according to claim 1, wherein said cleaning of said cleaning is further comprised of the steps of:

    degreasing said substrate; and

    ultrasonically cleaning said substrate.

3. The method for creating a buffer layer on a superconductor, according to claim 1, wherein said polishing of said substrate is further comprised of the step of:

    electropolishing said substrate.

4. The method for creating a buffer layer on a superconductor, according to claim 1, wherein said etching of said substrate is further comprised of the step of:

    sputter etching said substrate.

5. The method for creating a buffer layer on a superconductor, according to claim 1, wherein said depositing of said portion of said target on said substrate is further comprised of the steps of:

    impinging excited argon molecules on said target of strontium titanate;

    creating a plume of particles of strontium titanate; and

    depositing said particles of strontium titanate on said substrate.

6. The method for creating a buffer layer on a superconductor, according to claim 1, wherein said impinging of said laser beam on said deposit layer is further comprised of the steps of:

    directing a laser beam from a coherent $CO_2$ laser source onto a portion of said deposit layer;

    impinging said portion of said deposit layer with said laser beam; and

    orienting a molecular face of said deposit layer.

7. A superconductor which is comprised of:

    a metallic substrate having first and second sides;

    a buffer layer first and second sides and a 100 molecular face such that said first side of said buffer layer contacts said second side of said substrate and said buffer layer being further comprised of strontium titanate such that said 100 face of said buffer layer is approximately normal to said second side of said substrate; and

    a superconductor layer which is further comprised of adjacent molecules of $YBa_2 Cu_3O_{7-x}$ and having first and second sides such that said first side of said superconductor layer contacts said second side of said buffer layer and said copper atoms of said adjacent molecules of $YBa_2 Cu_3O_{7-x}$ being substantially in horizontal alignment along a portion of said superconductor layer.

8. A method for creating a high density capacitor having a substrate which is comprised of the steps of:

    cleaning said substrate;

    polishing said substrate;

    etching said substrate;

    depositing a portion of a target of strontium titanate on said substrate by RF sputtering to form a deposit layer on said substrate; and

    cooling said deposit layer.

9. The method for creating a high density capacitor, according to claim 8, wherein said cleaning of said cleaning is further comprised of the steps of:

degreasing said substrate; and

ultrasonically cleaning said substrate.

10. The method for creating a high density capacitor, according to claim 8, wherein said polishing of said substrate is further comprised of the step of:

electropolishing said substrate.

11. The method for creating a high density capacitor, according to claim 8, wherein said etching of said substrate is further comprised of the step of:

sputter etching said substrate.

12. The method for creating a high density capacitor, according to claim 8, wherein said depositing of said portion of said target on said substrate is further comprised of the steps of:

impinging excited argon molecules on said target of strontium titanate;

creating a plume of particles of strontium titanate; and

depositing said particles of strontium titanate on said substrate.

13. A high density capacitor which is comprised of:

a metallic substrate having first and second sides; and

a capacitive layer having first and second sides and a 100 molecular face such that said first side of said capacitive layer contacts said second side of said substrate and said capacitive layer bring further comprised of strontium titanate such that said 100 face of said capacitive layer is approximately normal to said second side of said substrate.

14. A method for creating a superconductor having a metallic substrate with first and second sides, a buffer layer having first and second sides, a target of strontium titanate, and a superconductor layer of $YBa_2Cu_3O_{7-x}$ having first and second sides which is comprised of the steps of:

cleaning said substrate;

polishing said substrate;

etching said substrate;

depositing a portion of said target of strontium titanate on said second side of said substrate to create said buffer layer,

cooling said buffer layer and substrate;

impinging a laser beam on said second side of said buffer layer, and

depositing said superconductive layer on said second side of said buffer layer.

FIG. 1

C AXIS

35

33

35

(100)
FACE

(100)
FACE

32

BUFFER
SrTiO₃

4

SUBSTRATE

FIG. 2

EP 0 507 539 A2

FIG. 3

EP 0 507 539 A2

# FIG. 4A

ROCKING CURVE
$SrTiO_3$ FILM ON
SINGLE CRYSTAL
$SrTiO_3$
ABOUT THE
200 PEAK

CNTS / SEC

THETA

EP 0 507 539 A2

# FIG. 4B

ROCKING CURVE
SrTiO$_3$ FILM AFTER
LASER RECRYSTALLIZATION
ABOUT THE 200 PEAK

CNTS / SEC

THETA

EP 0 507 539 A2

ORIENTED STRONTIUM TITANATE

*FIG. 5*

SUBSTRATE